**Europäisches Patentamt**

**European Patent Office**

**Office européen des brevets**

(11) Veröffentlichungsnummer: **0 307 725 B1**

(12) **EUROPÄISCHE PATENTSCHRIFT**

(45) Veröffentlichungstag der Patentschrift: **08.12.93**

(21) Anmeldenummer: **88114247.5**

(22) Anmeldetag: **01.09.88**

(51) Int. Cl.⁵: **H03G 3/32**, H03G 5/16

(54) **Schaltung zur Störgeräuschkompensation.**

(30) Priorität: **12.09.87 DE 3730763**

(43) Veröffentlichungstag der Anmeldung:
**22.03.89 Patentblatt 89/12**

(45) Bekanntmachung des Hinweises auf die
Patenterteilung:
**08.12.93 Patentblatt 93/49**

(84) Benannte Vertragsstaaten:
**AT DE FR GB IT**

(56) Entgegenhaltungen:
**DE-A- 2 456 468**
**FR-A- 2 529 727**

**ELEKTRONIK, Band 35, Nr. 17, August 1986,
Seiten 115-118, München, DE; H. GERMER et
al.: "Störgeräuschabhängige Lautstärkeautomatik im Autoradio"**

(73) Patentinhaber: **Blaupunkt-Werke GmbH
Postfach 77 77 77,
Robert-Bosch-Strasse 200
D-31132 Hildesheim(DE)**

(72) Erfinder: **Zwicker, Eberhard, Prof. Dr.-Ing.
Walchstadter Strasse 38
D-8021 Icking(DE)**
Erfinder: **Deuter, Klaus
Mittlerer Graben 4
D-8050 Freising(DE)**

(74) Vertreter: **Eilers, Norbert, Dipl.-Phys.
Blaupunkt-Werke GmbH,
Patente und Lizenzen,
Postfach 77 77 77
D-31132 Hildesheim (DE)**

**Beschreibung**

Die Erfindung betrifft eine Schaltung für ein Gerät für die Wiedergabe von akustischen Nutzsignalen zur Kompensation von Maskierungen des Nutzsignals durch Störgeräusche.

Bei der Wiedergabe von Runkfunksendungen oder Tonbandaufzeichnungen in einem Fahrzeug wird das vom Lautsprecher des Gerätes abgegebene akustische Nutzsignal durch Störgeräusche beeinträchtigt, deren Lautstärke wechselt. Die Störgeräusche überlagern sich dem Nutzsignal und das Nutzsignal wird dadurch ganz oder teilweise verdeckt, d. h. das Nutzsignal wird durch das Störgeräusch maskiert.

Das Störgeräusch hängt u. a. ab von der Fahrgeschwindigkeit, dem Karosserieaufbau und der Innenausstattung des Fahrzeugs sowie der Besetzung des Fahrzeugs mit Fahrgästen wie auch Belüftung des Fahrgastraumes durch eventuell geöffnete Fenster oder durch einen laufenden Ventilator. Jede Änderung einer dieser Größen weckt den Wunsch in dem Hörer, den Lautstärkeregler für das akustische Nutzsignal zu betätigen, sei es um die Wiedergabe lauter oder leiser zu stellen. Nicht immer hat der Autofahrer eine Hand frei, den Regler zu verstellen; oder die Fahrsituation erlaubt ihm nicht, den Regler zu betätigen. Häufig wechselt auch die Lautstärke des Störgeräusches zu rasch, um ihr mit der Reglerbetätigung zu folgen.

Das Nutzsignal wird zwar in einem Fahrzeug den Charakteristiken des eingesetzten Endverstärkers entsprechend naturgetreu wiedergegeben. Der subjektive Eindruck der Wiedergabetreue leidet aber infolge der Maskierung durch die Störgeräusche. So kann das Störgeräusch, das ein momentanes Beschleunigen des Fahrzeugs hervorruft, leicht eine Pianostelle in einem Klavierkonzert verdecken. Subjektiv müßte somit beim Beschleunigen die Lautstärke angehoben werden, damit die Pianostelle noch vernehmbar bleibt. Hinzu kommt, daß sich das Frequenzspektrum des Störgeräusches nicht mit dem Frequenzspektrum des akustischen Neutzsignals deckt. Daher kommt es bei Störgeräuschen auch stets zu Klangverfälschungen.

Der Erfindung lag die Aufgabe zugrunde, eine Schaltung anzugeben, die hilft, um die aufgezeigte Maskierung des Nutzsignals durch ein Störgeräusch zu kompensieren.

Die bekannten Verfahren zur selbständigen Lautstärkeregelung in Fahrzeugen reichen dazu nicht aus. Nach diesen bekannten Verfahren, z. B. DE 24 56 468 A1, wird ein regelbarer Verstärker in den elektrischen Übertragungsweg der wiederzugebenden Signale geschaltet, dessen Verstärkung durch eine Stellgröße geregelt wird. Die Stellgröße wird entweder aus der Fahrgeschwindigkeitsmessung oder aus der Motordrehzahlmessung oder auch über ein Mikrofon, wie z. B. in FR 25 29 727 A1 beschrieben, gewonnen, welches auch das vom Motor ausgehende Störgeräusch ziemlich gut zu messen gestattet.

Wenn auch ein solches Mikrofon keineswegs alle Störgeräusche, deren Ursachen eingangs geschildert wurden, erfaßt, so kann es in erster Näherung doch als das Störgeräusch mit der größten Dynamik und der größten Wechselgeschwindigkeit während der Betriebszeit eines Wiedergabegerätes angesehen werden. Auch die erfindungsgemäße Schaltung geht von der Verfügbarkeit einer solchen Stellgröße aus, schließt aber eine andersartige Gewinnung der Stellgröße nicht aus.

Die erfindungsgemäße Schaltung ist durch die im Anspruch 1 zusammengefaßten Merkmale gekennzeichnet.

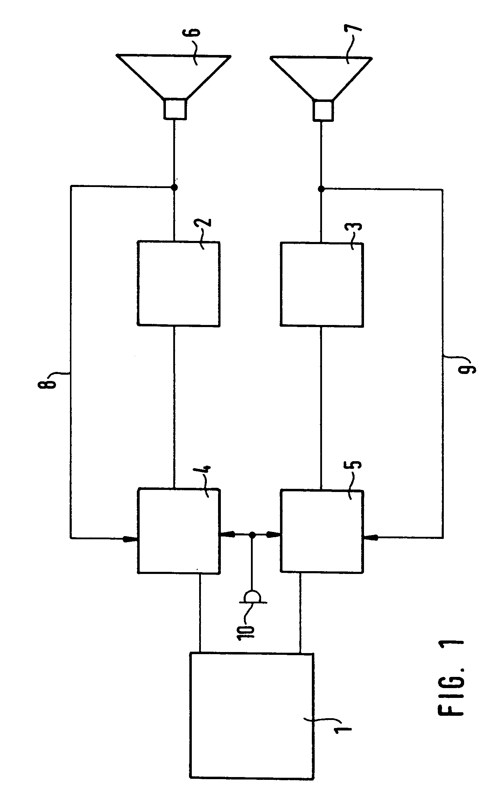

Anhand der Blockschaltbilder in den Figuren 1 bis 4 wird die Erfindung und eines ihrer Ausführungsbeispiele näher erläutert.

Die beiden Tonkanäle des stereofonen Wiedergabegerätes 1 sind jeweils durch eine Niederfrequenz-Endverstärkerstufe 2, 3 abgeschlossen, in deren Eingang je eine erfindungsgemäße Schaltung 4, 5 eingeschleift ist. Der Ausgang jeder Endstufe 2, 3 ist mit einem Lautsprecher 6, 7 verbunden, die das akustische Nutzsignal abgeben. Vom Ausgang der Endstufe 2, 3 führt jeweils eine Meßleitung 8, 9 zurück zu den vorgeschalteten erfindungsgemäßen Schaltungen 4 und 5.

Außerdem sind diese Schaltungen mit einem Störgeräuschaufnehmer 10 verbunden.

Die erfindungsgemäße Schaltung basiert auf dem Pegelvergleich zwischen Nutz- und Störsignal in drei getrennten Frequenzbändern. Durch drei zugeordnete Regelkreise werden die Pegelunterschiede zwischen Nutz- und Störsignal im zeitlichen Mittel auf bestimmten, kanalweise einstellbaren Werten gehalten. Damit wird das Nutzsignal an Spektrum und Pegel des Störsignals angepaßt, jedoch auch in der Dynamik eingeengt.

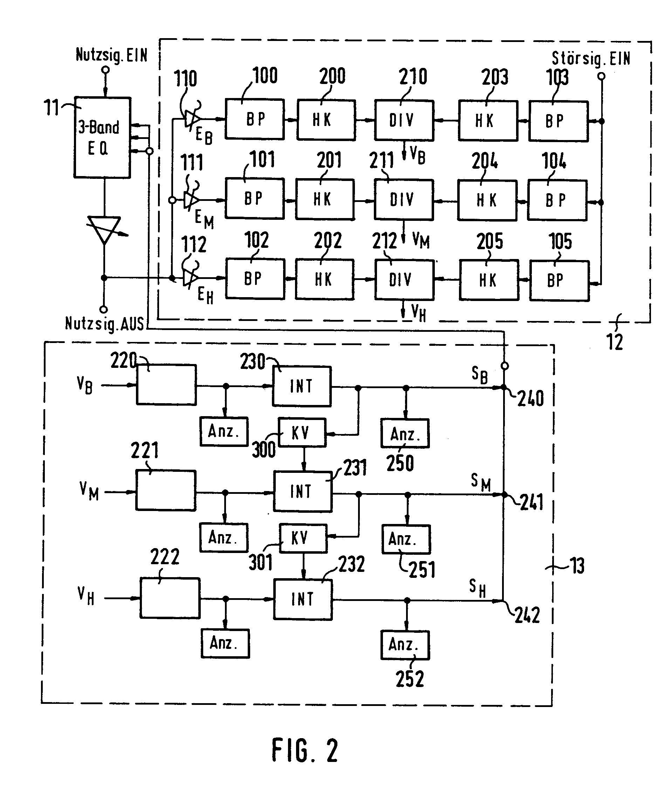

Jede erfindungsgemäße Schaltung 4, 5 besteht, wie in Fig. 2 dargestellt, aus einem steuerbaren 3-Band-Equalizer 11 und einem Vergleicher, der an einem Analyseteil 12 und einem Steuerteil 13 aufgebaut ist. Das Analyseteil 12 umfaßt u. a. drei Oktavbandpässe 100 - 102 sowohl für das Nutzsignal als auch drei Oktavbandpässe 103 - 105 für das Störgeräusch. Den Bandpässen sind jeweils Hüllkurvendetektoren 200 - 205 nachgeschaltet, deren Ausgangssignale zum Amplitudenvergleich je einem Analogdividierer 210, 211, 212 zugeführt werden.

EP 0 307 725 B1

Im Eingang des Steuerteils 13 liegt für jeden Steuerkanal ein Schwellwertentscheider 220, 221, 222, in dem das Ausgangssignal der Analogdividierer mit vorgegebenen Schwellen verglichen wird. Jeder Schwelle entspricht eine andere Änderungsgeschwindigkeit der Spannung am Ausgang 240, 241, 242 eines Integrators 230, 231, 232. Die Größe dieser Spannungen lassen sich an den Anzeigeeinheiten 250, 251, 252 ablesen. Sie bildet ein Steuersignal für die Stellglieder in dem steuerbaren 3-Band-Equalizer, so daß der Regelkreis geschlossen ist.

Der gleichspannungsgesteuerte Equalizer erlaubt die getrennte Beeinflussung dreier Frequenzbänder mit Trennfrequenzen bei 300 Hz und 2 000 Hz. Im Ruhezustand (alle Steuerspannungen gleich Null) besitzt der Equalizer eine frequenzunabhängige Dämpfung von 20 dB.

Davon ausgehend ist in jedem Band eine Anhebung um 20 dB möglich, so daß in voll geöffnetem Zustand eine frequenzunabhängige Dämpfung von 0 dB vorliegt. Die Ansteuerung geschieht dabei pegellinear mit einer Empfindlichkeit von 2 dB pro Volt.

Der Analyseteil 12 besitzt ebenfalls 3 Kanäle mit Trennfrequenzen bei 300 und 2 000 Hz und zwar sowohl für das Nutzsignal wie für das Störsignal.

Im Analyseteil 12 wird das Nutzsignal über drei Eichleitungen 110, 111, 112 den drei Oktavbandpässen 100 - 102 zugeführt. Dabei sind die Eichleitungen in 2 dB-Schritten von 0 - 18 dB-Dämpfung kalibriert einstellbar und dienen zur Einstellung des mittleren Pegelunterschiedes. Die Oktavbandpässe weisen Mittenfrequenzen von 100 Hz (Baßkanal), 700 Hz (Mittenkanal) und 4 400 Hz (Höhenkanal) auf, es handelt sich um Oktavbandpässe vierten Grades. In den nachfolgenden Hüllkurvendemodulatoren 200 - 205 wird das Signal doppelweggleichgerichtet und mit Anstiegs- und Abfallzeitkonstanten bewertet. Diese Zeitkonstanten werden für jeden einzelnen Demodulator hinsichtlich der Frequenzlage und der Beschaffenheit des Signals optimiert. Bei einer solchen Optimierung wurden die Zeitkonstanten entsprechend Tab. 1 gewählt.

**Tabelle 1**

|  | Baßkanal | Mittenkanal | Höhenkanal |
|---|---|---|---|
| **Nutzsignal:** |  |  |  |
| $t_{Anstieg}$ | 1 ms | 1 ms | 1 ms |
| $t_{Abfall}$ | 1 500 ms | 500 ms | 500 ms |
| **Störsignal:** |  |  |  |
| $t_{Anstieg}$ | 1 ms | 1 ms | 50 ms |
| $t_{Abfall}$ | 500 ms | 300 ms | 200 ms |

Dabei zeigt sich, daß die Anstiegszeit der Hüllkurvendemodulatoren 200 - 205 für beide Signale klein gegenüber deren Abfallzeit ist und daß die Abfallzeiten in den höherfrequenten Bändern geringer sind als die in den tieferfrequenten Bändern.

Das eingespeiste Störgeräusch wird direkt den zugeordneten Oktavbandpässen zugeführt. Die Zeitkonstanten der diesen Bandpässen nachgeschalteten Hüllkurvendemodulatoren weichen, wie aus Tab. 1 ersichtlich, von denen des Nutzsignals ab. Die so kanalweise gewonnenen Hüllkurven von Nutz- und Störsignal werden nun zur Auswertung des Pegelunterschiedes in einem Analogdividierer 210 - 212 durcheinander dividiert. Dabei wird die augenblickliche Signal-Amplitude der Hüllkurve des Nutzsignalkanals in Bezug gebracht zur augenblicklichen Signalamplitude der Hüllkurve des Störgeräuschkanals. Die als Ausgangsgröße erzeugten Amplitudenverhältnisse bilden die Eingänge für den Steuerteil 13.

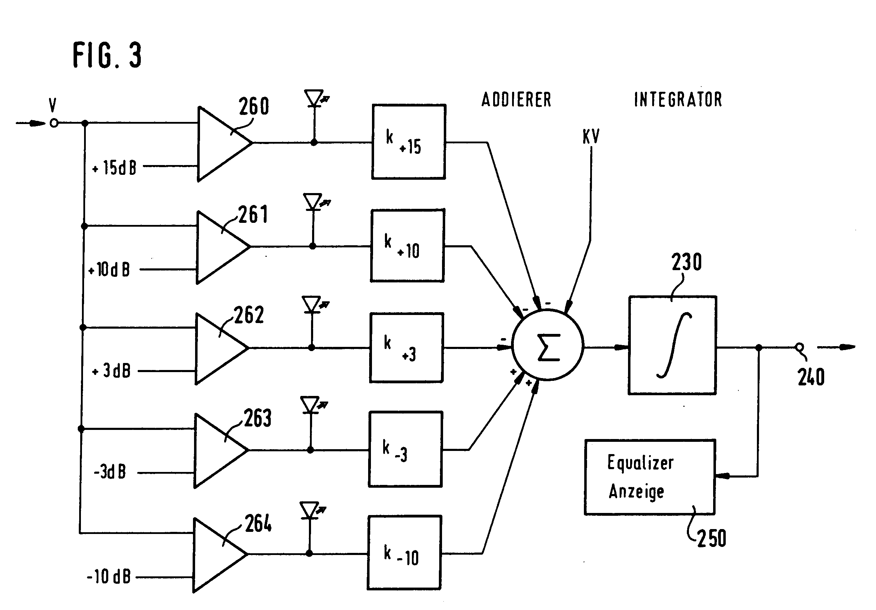

Die im Eingang des Steuerteils 13 liegenden Schwellwertentscheider 220, 221, 222, sind in Figur 3 näher dargestellt. Die Ausgangsspannung der Dividierer wird zunächst in einem fünfstufigen Komparator 260 - 264 mit fünf Schwellen verglichen, die Pegelunterschiede zwischen Nutz- und Störsignal von 15 dB, 10 dB, 3 dB, -3 dB und -10 dB entsprechen. Die fünf Einzelkomparatoren steuern jeweils eine Leuchtdiode

3

für die optische Überwachung der Arbeitsweise der erfindungsgemäßen Schaltung an. Außerdem werden die Ausgangssignale der fünf Komparatoren mit Faktoren $k_i$ gewichtet und entsprechend dem Vorzeichen addiert in den Integrator 230 eingespeist. Dieser ändert beim Ansprechen eines Komperators seine Ausgangsspannung mit einer Geschwindigkeit, die dem jeweiligen Faktor $k_i$ entspricht.

Die Werte der Faktoren $k_i$, ausgedrückt in der resultierenden Änderungsgeschwindigkeiten der Dämpfung im gesteuerten Equalizer (in dB/Sekunde) sind für eine optimierte Schaltungsversion in der nachfolgenden Tabelle 2 angegeben.

Tabelle 2

| Stufe: | Baßkanal | Mittenkanal | Höhenkanal |
|---|---|---|---|
| + 15 dB | 7,0 dB/ | 7 dB/ | 7 dB/ |
| + 10 dB | 16,0 dB/s | 48 dB/s | 86 dB/s |
| + 3 dB | 2,0 dB/s | 6 dB/s | 14 dB/s |
| - 3 dB | 2,3 dB/s | 5 dB/s | 9 dB/s |
| -10 dB | 8,5 dB/s | 33 dB/s | 54 dB/s |

Danach ist die Änderungsgeschwindigkeit bei Signalverhältnissen von + 10 dB und -10 dB wesentlich größer als bei anderen Signalverhältnissen zu wählen.

Die vom Integratorausgang gespeiste Equalizeranzeige 250 zeigt auf einer zehnteiligen LED-Skala die aktuelle Dämpfungseinstellung des Equalizers in zwei dB-Stufen von -20 bis 0 dB an.

Bei Störgeräuschen mit sehr starken tieffrequenten Anteilen kann es dazu kommen, daß der Baßkanal in eine hohe Anhebung gesteuert wird, während der Mitten- und Höhenkanal annähernd in Ruhelage bleiben. Da dies zu einem unbefriedigenden Klangbild führt, hebt in diesem Fall durch Kanalverkettung der Baßkanal über ein Kettenglied 300 den Mittenkanal sowie der Mittenkanal über ein Kettenglied 301 den Höhenkanal mit an. Es sind zwischen den jeweiligen Kanälen feste Anhebungsverhältnisse von 10 zu 3 (Baß-/Mitten-Kanal) und 10 zu 7,25 (Mitten-/Höhenkanal) eingestellt. Das bedeutet, daß z. B. bei einer Anhebung des Baßkanals von 20 dB der Mittenkanal durch die Kanalverkettung um 6 und dadurch wiederum der Höhenkanal um rd. 4,5 dB geöffnet wird.

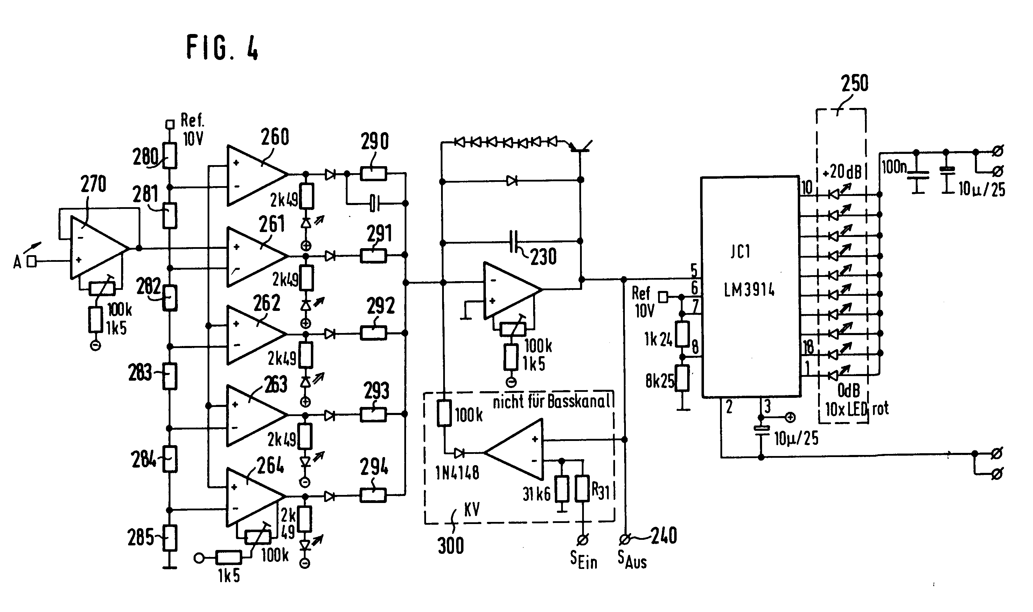

Wie Fig. 4 zeigt, besteht der erwähnte Komparator-Block aus einem Pufferverstärker 270 sowie den Komparatoren 260 - 264. Eine Spannungsteilerkette 280 - 285 legt die fünf Schaltschwellen fest. Die Widerstände 290 - 294 im Ausgang der Komparatoren bestimmten die jeder Schaltschwelle zugeordnete Änderungsgeschwindigkeit, der Spannung am Ausgang 240 des Integrators 230 und damit die der Equalizereinstellung.

Das RC-Glied in der Ausgangsleitung des Komparators 260 bewirkt im Fall des Ansprechens des Komparators (entsprechend Nutzsignal 15 dB über Störsignal) eine schlagartige Absenkung der Equalizerstellung um 7 dB (Notbremsenfunktion).

Die Dioden-Transistoranordnung parallel zum Integrationskondesator 230 begrenzt die Ausgangsspannung auf maximal 10 Volt.

**Patentansprüche**

1. Schaltung für ein Gerät für die Wiedergabe akustischer Signale zur Kompensation von Maskierungen des Nutzsignals durch Störgeräusche,
   dadurch gekennzeichnet,
   daß in ihr das Nutzsignal, in mehrere Frequenzbänder aufgeteilt, einen entsprechend mehrkanaligen Equalizer (11) durchläuft, daß das Störgeräusch in mehreren Bandpässen (103 - 105) in entsprechende Frequenzbänder aufgeteilt wird, daß die Ausgangssignale dieser Bandpässe, die Störsignalkomponenten, mit den Ausgangssignalen der entsprechenden Equalizer-Kanäle, den Nutzsignalkomponenten, in einem Analyseteil (12) verglichen werden, und daß die Richtung und Geschwindigkeit der Stellgliedänderung im Equalizer (11) in Abhängigkeit von den Signalen an den Ausgängen (240, 241, 242) des Analyseteils (12) gesteuert wird.

2. Schaltung nach Anspruch 1,
   dadurch gekennzeichnet,
   daß in dem Analyseteil (12) die Hüllkurven der Ausgangssignale der Bandpässe (103 - 105) und die Hüllkurven der Ausgangssignale entsprechender Bandpässe (100 - 102) in den Kanälen des Equalizer-

4

EP 0 307 725 B1

signals miteinander verglichen werden.

3. Schaltung nach Anspruch 2,
dadurch gekennzeichnet,
daß die Anstiegszeiten der Hüllkurven-Demodulatoren (200 - 205) für das Nutzsignal und das Störgeräusch sehr klein gegenüber ihren Abfallzeiten sind.

4. Schaltung nach Anspruch 2 oder 3,
dadurch gekennzeichnet,
daß die Abfallzeiten der Hüllkurven-Demodulatoren (200 - 205) in den höherfrequenten Bändern geringer sind als die in den tieferfrequenten Bändern.

5. Schaltung nach Anspruch 4 oder einem der vorhergehenden Ansprüche,
dadurch gekennzeichnet,
daß im Analyseteil (12) das Verhältnis der Signalamplituden der zu vergleichenden Hüllkurvensignale gebildet wird.

6. Schaltung nach Anspruch 4 oder einem der vorhergehenden Ansprüche,
dadurch gekennzeichnet,
daß im Analyseteil (12) die Differenz der Signalamplituden der zu vergleichenden Ausgangssignale gebildet wird.

7. Schaltung nach Anspruch 5,
dadurch gekennzeichnet,
daß im Analyseteil (12) in einem Analogdividierer (210, 211, 212) die jeweilige Nutzsignalkomponente auf die entsprechende Störgeräuschkomponente bezogen wird.

8. Schaltung nach Anspruch 7 oder einem der vorhergehenden Ansprüche 1 - 4,
dadurch gekennzeichnet,
daß in einem dem Analyseteil nachgeschalteten Steuerteil (13) die Ausgangssignale der einzelnen Analogdividierer (210, 211, 212) in zugeordneten mehrstufigen Komparatorschaltungen (220, 221, 222) mit vorgegebenen Sollwerten verglichen werden und die Ausgangssignale der ansprechenden Komparatoren (260 - 264) gewichtet, danach addiert und schließlich in einem Integrator (230, 231, 232) integriert werden.

9. Schaltung nach Anspruch 8,
dadurch gekennzeichnet,
daß als Komparatoren Operationsverstärker (260 - 264) eingesetzt sind, deren einem Eingang das Ausgangssignal des zugeordneten Analogdividierers (210 - 212) über einen Pufferverstärker (270) zugeführt wird, während die zweiten Eingänge an unterschiedlichen Abgriffen eines aus mehreren Widerständen (280 - 285) gebildeten Spannungsteilers liegen, und daß die Ausgänge der Operationsverstärker über unterschiedlich große Widerstände (290 - 294) parallel mit dem Integrator-Kondensator (230, 231, 232) verbunden sind und, indem sie dessen Ladegeschwindigkeit und -richtung bestimmen, auch die entsprechende Änderung der Stellglieder in dem Equalizer (11) bewirken.

10. Schaltung nach Anspruch 9 oder einem der vorhergehenden Ansprüche 1 - 8,
dadurch gekennzeichnet,
daß die Signale an den Ausgängen (240 - 242) der einzelnen Integratoren (230 - 232) untereinander über Kettenglieder (300, 301) verkettet sind.

Claims

1. Circuit for a device for the playback of acoustic signals in order to compensate maskings of the wanted signal by disturbing noises, characterised in that in the circuit the wanted signal, divided into a plurality of frequency bands, passes through a correspondingly multi-channel equalizer (11), in that the disturbing noise in a plurality of band-pass filters (103 - 105) is divided into corresponding frequency bands, in that the output signals of these band-pass filters, the noise signal components, are compared in an analysis part (12) with the output signals of the corresponding equaliser channels, the wanted

5

signal components, and in that the direction and rate of change of the actuator in the equalizer (11) is controlled as a function of the signals at the outputs (240, 241, 242) of the analysis part (12).

2. Circuit according to Claim 1, characterised in that in the analysis part (12) the envelopes of the output signals of the band-pass filters (103 - 105) and the envelopes of the output signals of corresponding band-pass filters (100 - 102) in the channels of the equalizer signal are compared with one another.

3. Circuit according to Claim 2, characterised in that the rise times of the envelope demodulators (200 - 205) for the wanted signal and the disturbing noise are very small by comparison with their fall times.

4. Circuit according to Claim 2 or 3, characterised in that the fall times of the envelope demodulators (200 - 205) are shorter in the higher frequency bands than those in the lower frequency bands.

5. Circuit according to Claim 4 or one of the preceding claims, characterised in that in the analysis part (12) the ratio of the signal amplitudes of the envelope signals to be compared is formed.

6. Circuit according to Claim 4 or one of the preceding claims, characterised in that in the analysis part (12) the difference of the signal amplitudes of the output signals to be compared is formed.

7. Circuit according to Claim 5, characterised in that in the analysis part (12) the respective wanted signal component is referred in an analog divider (210, 211, 212) to the corresponding disturbing noise component.

8. Circuit according to Claim 7 or one of the preceding Claims 1 - 4, characterised in that in a control part (13) connected downstream of the analysis part the output signals of the individual analog dividers (210, 211, 212) are compared in assigned multistage comparator circuits (220, 221, 222) with prescribed desired values and the output signals of the responding comparators (260 - 264) are weighted, thereafter added and finally integrated in an integrator (230, 231, 232).

9. Circuit according to Claim 8, characterised in that use is made as comparators of operational amplifiers (260 - 264) to the one input of which the output signal of the assigned analog divider (210 - 212) is fed via a buffer amplifier (270), while the second inputs are connected to different taps of a voltage divider formed from a plurality of resistors (280 - 285), and in that the outputs of the operational amplifiers are connected in parallel with the integrator-capacitor (230, 231, 232) via resistors (290 - 294) of different size and determine the rate and direction of charging of said integrator-capacitor as well as effecting the corresponding change in the actuators in the equalizer (11).

10. Circuit according to Claim 9 or one of the preceding Claims 1 - 8, characterised in that the signals at the outputs (240 - 242) of the individual integrators (230 - 232) are interlinked via linking elements (300, 301).

**Revendications**

1. Circuit pour un appareil de reproduction de signaux acoustiques pour la compensation de masquages du signal utile par des bruits parasites, circuit caractérisé en ce que le signal utile, subdivisé en plusieurs bandes de fréquence, parcourt un égaliseur correspondant (11) à plusieurs canaux, en ce que le bruit parasite est subdivisé en plusieurs passe-bandes (103 à 105) selon des bandes de fréquence correspondantes, en ce que les signaux de sortie de ces passe-bandes, les composantes du signal parasite, sont comparés avec les signaux du sortie des canaux correspondants de l'égaliseur, las composantes de signal utile, dans une partie d'analyse (12), et en ce que le sens de la vitesse de modification de l'organe de réglage de l'égaliseur (11) est commandé en fonction des signaux aux sorties (240, 241, 242) de la partie d'analyse (12).

2. Circuit selon la revendication 1, caractérisé en ce que dans la partie d'analyse (12), les courbes enveloppes des signaux de sortie des passe-bandes (103 à 105) et les courbes enveloppes des signaux de sortie des passe-bandes correspondants (100 à 102) dans les canaux du signal de l'égaliseur sont comparées entre elles.

**3.** Circuit selon la revendication 2, caractérisé en ce que les temps d'accroissement des démodulateurs de courbes enveloppes (200 à 205) pour le signal utile et le bruit parasite, sont très petits par rapport à leur temps de décroissance.

**4.** Circuit selon la revendication 2 ou la revendication 3, caractérisé en ce que les temps de décroissance des démodulateurs de courbes enveloppes (200 à 205) sont plus réduits dans les bandes haute fréquence que dans les bandes basse fréquence.

**5.** Circuit selon la revendication 4 ou une des précédentes, caractérisé en ce que le rapport des amplitudes des signaux de courbes enveloppes à comparer, est formé dans la partie d'analyse (12).

**6.** Circuit selon la revendication 4 ou une des précédentes, caractérisé en ce que la différence des amplitudes des signaux de sortie à comparer est formée dans la partie d'analyse (12).

**7.** Circuit selon la revendication 5, caractérisé en ce que dans la partie d'analyse (12), les composantes respectives du signal utile sont rapportées à la composante correspondante du bruit parasite dans un diviseur analogique (210, 211, 212).

**8.** Circuit selon la revendication 7 ou une des précédentes revendications 1 à 4, caractérisé en ce que dans une partie de commande (13) branchée à la suite de la partie d'analyse, les signaux de sortie des différents diviseurs analogiques (210, 211, 212) sont comparés avec des valeurs de consigne prédéfinies dans des circuits comparateurs à plusieurs étages associés (220, 221, 222) et les signaux de sortie des comparateurs correspondants (260 à 264) sont pondérés, puis totalisés et finalement intégrés dans un intégrateur (230, 231, 232).

**9.** Circuit selon la revendication 8, caractérisé en ce que en tant que comparateurs, sont mis en oeuvre des amplificateurs opérationnels (260 à 264), à une entrée desquels est appliqué par l'intermédiaire d'un amplificateur tampon (270), le signal de sortie du diviseur analogique associé (210, 212), tandis que les secondes entrées s'appliquent à différentes prises d'un diviseur de tension formé de plusieurs résistances (280 à 285), et on ce que les sorties de l'amplificateur opérationnel sont reliées en parallèle par l'intermédiaire de résistances de grandeur différente (290 à 294) à l'intégrateur condensateur (230, 231, 232), et du fait qu'elles déterminent sa vitesse et son sens de charge, elles assurent également la modification correspondante des organes de réglage dans l'égaliseur (11).

**10.** Circuit selon la revendication 9 ou une des précédentes revendications 1 à 8, caractérisé en ce que les signaux aux sorties (240, 242) des différents intégrateurs (230, 232) sont enchaînés ensemble par l'intermédiaire d'organes d'enchaînement (300, 301).

FIG. 1

FIG. 2

FIG. 3

FIG. 4

EP 0 307 725 B1